# EUROPEAN PATENT APPLICATION

(11) **EP 0 909 116 A2**
(43) Date of publication of application: **14.04.1999**
(21) Application number: 98308242.1
(22) Date of filing: 09.10.1998
(51) Int. Cl.: H05G 1/10

(54) **High-voltage power supply unit particularly for x-ray sources**

(30) Priority: 09.10.1997 FR 9712608
(71) Applicant: GE MEDICAL SYSTEMS SA, 78533 Buc Cedex (FR)
(72) Inventor: Jedlitschka, Hans W. A., 92320 Chatillon (FR)
(74) Representative: Pedder, James Cuthbert

(57) **Abstract**

A high-voltage power supply unit (1) has electrical components (2, 3, 4) encased in insulating casings (5, 6, 7) which are biodegradable. The insulating casings (5, 6, 7) comprise several superimposed layers, joined together, of sheets of paper, the number of layers being chosen in order to obtain the desired amount of electrical insulation to suit the strength of the electric field surrounding the insulated electrical components (2, 3, 4) when the unit is in operation.

The application is particularly relevant to the provision of power to X-ray sources.

## Description

The present invention relates in general to high-voltage (HT) power supply units, particularly for X-ray sources, which units are biodegradable.

Conventional HT power supply units include components which are encased in electrically insulating cases. These components are arranged in an earthed box which is vacuum filled with an electrically insulating and cooling medium. The casings of the components are generally made by injection-molding of plastic. These injection-molded plastic casings need to be free of geometric defects and not to contain inclusions of gas which will detract from electrical insulation.

The plastic insulating casings and the insulating oil represent most (greater than 60% by volume) of the HT power supply unit, and this poses problems with recycling and safety and with respect to the environment.

Furthermore, it would be desirable to choose the thickness of the casings to suit the strength of the surrounding electrical field. Altering the thickness in this way is not compatible with injection-molding techniques which require a constant thickness in order to avoid geometric defects and/or inclusions of gas.

It would be desirable to provide a HT power supply units in which the materials used to insulate the electrical components readily allow the thickness of the insulation to be altered to suit the strength of the electric field that there is around the component and which are preferably biodegradable.

According to the invention, there is provided a high-voltage power supply unit comprising electrical components encased in electrically insulating casings wherein the insulating casings are biodegradable and comprise several superimposed layers, joined together, of sheets of paper, the number of layers being chosen in order to obtain the desired amount of electrical insulation to suit the strength of the electric field surrounding the insulated electrical components when the unit is in operation.

Thus an embodiment of the invention is a power supply unit for which most of the materials used to make it are recyclable and do not have harmful effects on the environment, and in particular are biodegradable materials.

An embodiment of the invention is a biodegradable high-voltage power supply unit comprising electrical components encased in electrically insulating casings wherein the insulating casings comprise several superimposed layers, joined together, of sheets of paper, the number of layers being chosen in order to obtain the desired amount of electrical insulation to suit the strength of the electric field surrounding the insulated electrical components when the unit is in operation.

An embodiment of the present invention is therefore also a biodegradable HT power supply unit, particularly for X-ray sources, the electrical components of which are contained in insulating casings the thickness of which can readily be chosen to suit the strength of the surrounding electric field.

The invention will now be described in greater detail, by way of example, with reference to the drawings, in which:-

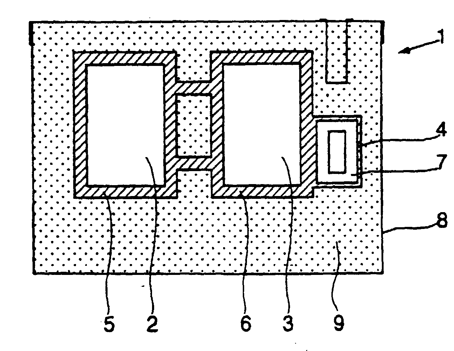

The single figure depicts a conventional layout of an HT power supply unit for X-ray sources.

Referring to figure, the HT power supply unit 1 comprises an HT transformer 2, a voltage multiplier/rectifier device 3, and an HT output device 4.

The components of the HT transformer 2, such as the windings, the components of the voltage multiplier/rectifier device and of the HT output device 4, such as the transistors, the smoothing capacitors and the resistors, are encased in electrically insulating casings 5, 6, and 7, respectively.

The HT transformer 2, the voltage multiplier/ rectifier device 3, the output device 4 and the appropriate electrical connections are arranged in an earthed metal box 8 vacuum-filled with an electrically insulating and cooling medium 9, such as a mineral oil, in order to obtain the desired resistance to the high voltages which are generally between 30 Kv and 150 Kv.

The electrically insulating casings 5, 6, and 7 of the HT transformer 2, of the voltage multiplier/rectifier device 3 and of the HT output device 4 are generally made by injection-molding of plastic. These injection-molded plastic casings need to be free of geometric defects and need to not contain inclusions of gas which detract from the electrical insulation.

An embodiment of the invention comprises a HT power supply unit in which the electrical components are encased in insulating casings comprising several superimposed layers, joined together, of sheets of paper. The number of sheets are chosen in order to obtain the desired amount of electrical insulation to suit the strength of the electric field surrounding the insulated electrical components when the HT power supply unit is in operation.

The layers of sheets of paper are generally joined together by an electrically insulating adhesive that can resist the insulating and cooling medium such as a mineral or vegetable oil. As a preference, use is made of a cellulose-based glue which is biodegradable.

In general, the layers of sheets of paper of which the casings are formed are impregnated with an insulating mineral or vegetable oil and compressed.

It has been discovered that a stack of five layers of sheets of paper 12 µm thick impregnated with conventional insulating mineral or vegetable oil is able to withstand a potential difference of 14 kv.

The stacks of sheets of paper can easily be pressed to make winding casings and boxes and lids and it is easy, during the manufacturing method for pressing to obtain different wall thicknesses by adding layers of sheets of paper.

It is recommended that the impregnation oil and the oil that constitutes the insulating and cooling medium should be an insulating vegetable oil such as grape seed oil. Such insulating vegetable oils are known and have dielectric properties comparable with insulating mineral oils and better vapor tensions. Furthermore, they have the advantage of being biodegradable and therefore not harmful to the environment.

## Claims

1. A high-voltage power supply unit comprising electrical components encased in electrically insulating casings wherein the insulating casings are biodegradable and comprise several superimposed layers, joined together, of sheets of paper, the number of layers being chosen in order to obtain the desired amount of electrical insulation to suit the strength of the electric field surrounding the insulated electrical components when the unit is in operation.

2. High-voltage power supply unit according to claim 1 wherein the superimposed layers of sheets of paper are impregnated with insulating mineral or vegetable oil.

3. High-voltage power supply unit according to claim 1 or 2 wherein the layers of sheets of paper are joined together by an electrically insulating adhesive.

4. High-voltage power supply unit according to claim 3 wherein the adhesive is a cellulose-based glue.

5. High-voltage power supply unit according to any one of Claims 1 to 4 comprising an electrically earthed metal casing filled with an electrically insulating and cooling medium within which electrical components are encased within the electrically insulating casings.

6. High-voltage power supply unit according to Claim 6 wherein the electrically insulating and cooling medium is an insulating vegetable oil.

7. High-voltage power supply unit according to any one of claims 1 to 6, for providing power to an X-ray source.
